# EUROPÄISCHE PATENTSCHRIFT

(11) **EP 0 498 321 B1**
(45) Veröffentlichungstag und Bekanntmachung des Hinweises auf die Patenterteilung: **22.11.1995**
(21) Anmeldenummer: 92101677.0
(22) Anmeldetag: 01.02.1992
(51) Int. Cl.: H03B 23/00, G06F 1/03

(54) **Verfahren zur Erzeugung eines modulierten hochfrequenten elektrischen Signales und Anordnung zur Durchführung des Verfahrens**
Method and device for producing a high frequency modulated electric signal
Méthode et dispositif pour la production d'un signal électrique modulé à haute fréquence

(30) Priorität: 05.02.1991 DE 4103401
(43) Veröffentlichungstag der Anmeldung: 12.08.1992
(73) Patentinhaber: Daimler-Benz Aerospace Aktiengesellschaft, 81663 München (DE)
(72) Erfinder: Hofele, Franz Xaver, Dipl.-Math., W-7322 Donzdorf (DE); Minker, Manfred, Dipl.-Ing., W-7900 Ulm (DE)
(74) Vertreter: Schulze, Harald Rudolf, Dipl.-Ing.

(56) Entgegenhaltungen:
- GB-A- 2 116 795
- PATENT ABSTRACTS OF JAPAN, vol. 12, no. 7 (E-571) 9. Januar 1988
- Proceedings of MELECON '87, 24-26 März 1987; S. 715-718, New York, US; BUCCIARELLO, PETTENELLO & SALVATI: "A DIGITAL IMPLEMENTATION OF CHIRPED WAVEFORM FOR SATELLITE APPLICATIONS"
- IEEE INSTRUMENTATION AND MEASUREMENT TECHNOLOGY CONFERENCE, 25-27. April, 1989, S. 233-237, New York, US; PEDERSEN: "DIGITALLY BASED COHERENT SWEEP GENERATOR"
- PATENT ABSTRACTS OF JAPAN, vol. 11, no. 11 (E-470) 13. Januar 1987

## Beschreibung

Die Erfindung betrifft ein Verfahren zur Erzeugung eines modulierten hochfrequenten elektrischen Signales nach dem Oberbegriff des Patentanspruchs 1 und eine Anordnung zur Durchführung des Verfahrens nach dem Oberbegriff des Patentanspruchs 6.

In vielen Anwendungsgebieten sind modulierte hochfrequente Signale erforderlich, z.B. sogenannte Chirp-Signale in der Radartechnik. Dieses sind hochfrequente Signale mit einer vorgegebenen Periodendauer, innerhalb der sich die Frequenz ändert, z.B. gemäß einer linear ansteigenden Funktion.

Solche Chirp-Signale können ein- oder mehrmalig oder periodisch ausgesandt werden. Weiterhin ist es zum Teil erwünscht, daß möglichst schnell zwischen verschiedenen Modulationsarten, z.B. Amplituden-, Phasen-, oder Frequenzmodulation, umgeschaltet werden kann. Für die beispielhaft erwähnte Radartechnik ist es erforderlich, daß diese Signale letztendlich sehr hochfrequent, d.h. z.B. im GHz-Bereich vorliegen müssen. Dieses erfolgt im allgemeinen durch Aufwärtsmischung eines entsprechenden Zwischenfrequenz (ZF)-Signales, das zweckmäßigerweise bereits in einem möglichst hohen Frequenzbereich liegen sollte.

Aber auch in anderen Anwendungsgebieten, z.B. der Prüftechnik, sind solche modulierten Signale erforderlich.

Aus GB-A-2 116 795 und "A digital implementation of a chirped waveform for satellite applications" von T.Buccianelli, V.Pettenello und A.Salviati (in IEEE-sponsored "Proceedings of MELECON′87", 24-26 März 1987, New York, USA, Seiten 715-718 veröffentlicht) sind digitale Chirp-Signal-Generatoren bekannt, die einen analogen Modulator benötigen, um ein SSB Signal zu erzeugen.

Der Erfindung liegt daher die Aufgabe zugrunde, ein Verfahren anzugeben, das in einfacher, gut reproduzierbarer und kostengünstiger Weise die Erzeugung möglichst hochfrequenter elektrischer Signale ermöglicht, die in verschiedenen Arten modulierbar sind und bei denen möglichst schnell von einer Modulationsart und/oder Signalform, z.B. Periodendauer des Signals, auf andere umgeschaltet werden kann. Der Erfindung liegt außerdem die Aufgabe zugrunde, eine Anordnung zur Durchführung eines solchen Verfahrens anzugeben.

Diese Aufgabe wird gelöst durch die in den kennzeichnenden Teilen der Patentansprüche 1 und 6 angegebenen Merkmale. Vorteilhafte Ausgestaltungen und/oder Weiterbildungen sind in den Unteransprüchen zusammengestellt.

Ein erster Vorteil der Erfindung besteht darin, daß das zu erzeugende sehr hochfrequente Signal zunächst in seiner Soll-Form in einem beliebigen Zeitbereich in Form von Stützwerten, die gespeichert werden, erzeugt werden kann. Dadurch ist es auf einfache Weise möglich, die Stützwerte zu ändern, z.B. so, daß ein sendeseitig vorverzerrtes Signal entsteht, durch welches eine zugehörige empfangsseitige Signalverarbeitung vereinfacht und/oder optimiert werden kann.

Ein zweiter Vorteil besteht darin, daß aus den gespeicherten Stützwerten ein Signal erzeugt wird, das im wesentlichen gleichzeitig sowohl in einem Basisband als auch in einem demgegenüber wesentlichen höheren Frequenzband, z.B. einem ZF-Band, vorliegt. Dadurch ist es z.B. möglich, diese beiden Signale für Test- und/oder Prüfzwecke sowie zur Optimierung einer Anlage, z.B. einer Radaranlage, zu verwenden.

Ein dritter Vorteil besteht darin, daß ein einmal festgelegter Amplituden- und/oder Phasenverlauf erhalten bleibt.

Ein vierter Vorteil besteht darin, daß das analoge Ausgangssignal ein sehr hochwertiges Zweiseitenbandsignal ist, so daß insbesondere mit mindestens einem nachgeschalteten phasenlinearen Bandpaß auf zuverlässige Weise entweder das obere oder das untere Seitenband gewählt werden kann. Diese Seitenbandsignale sind dann ebenfalls sehr hochwertig.

Die Erfindung wird im folgenden anhand eines Ausführungsbeispieles unter Bezugnahme auf schematische Zeichnungen näher erläutert. Dabei zeigen:
- FIG. 1: eine Darstellung eines beispielhaft modulierten Signales
- FIG. 2: ein beispielhaftes Blockschaltbild zur Erläuterung der Erfindung.

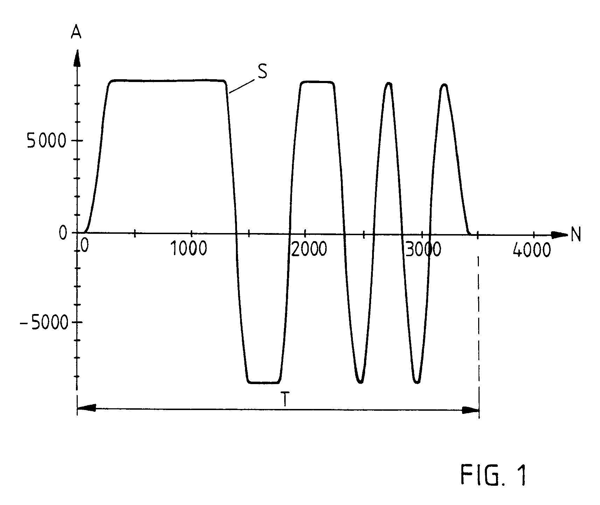

FIG. 1 zeigt eine Darstellung eines zu erzeugenden modulierten Signales S, das eine Periodendauer T besitzt. Diese ist in Zeitintervalle, hier z.B. 3500, unterteilt, die von Null beginnend durchnumeriert sind. Auf der Abszisse ist daher die Nummer N der Zeitintervalle, die auch als Stützstellen bezeichnet werden können, aufgetragen. Auf der Ordinate ist die Amplitude A linear in willkürlichen Einheiten aufgetragen. Auf diese Weise wird jeder Stützstelle (Zeitintervall) ein bestimmter Amplitudenwert, der auch Stützwert genannt wird, zugeordnet. Es ist nun sehr vorteilhaft, was nachfolgend noch näher erläutert wird, bei jeder zweiten Stützstelle, z.B. bei allen ungeraden Stützstellen, das Vorzeichen der zugehörigen Stützwerte zu ändern (invertieren). Die so bearbeiteten Stützwerte werden anschließend gespeichert, z.B. in mindestens einem PROM (Programmable Read Only Memory), dann der Reihe nach ausgelesen und in analoge Werte gewandelt. Die beschriebene Erstellung und Speicherung der Stützwerte erfolgt vorteilhafterweise mit Hilfe einer Datenverarbeitungsanlage sowie eines daran angeschlossenen Programmiergerätes für den mindestens einen Speicher.

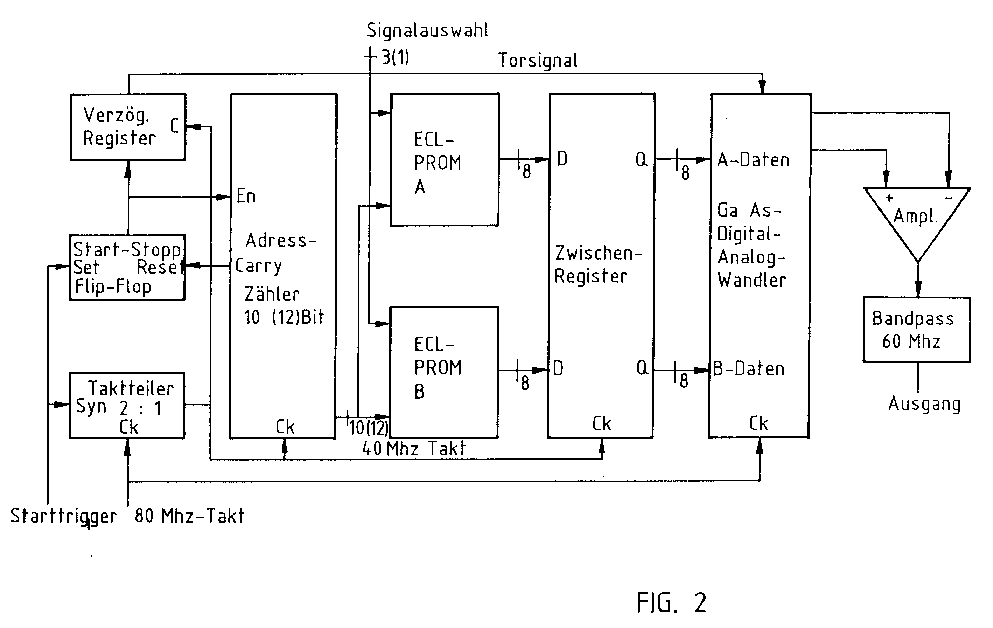

FIG. 2 zeigt eine besonders vorteilhafte Anordnung zum Speichern, Auslesen sowie D/A-Wandeln der Stützwerte. Dieser Vorteil besteht darin, daß die in digitaler Form vorliegenden Stützwerte eines Signales in niedriger Erzeugungsfrequenzlage durch den Vorzeichenwechsel der Abtastwerte direkt in ein hochwertiges Zweiseitenbandsignal höherer Frequenzlage transformiert werden. Es entsteht eine digitale und somit ideale Doppelgegentaktmodulation. Die nachfolgend beschriebene Anordnung ist aufgebaut aus wenigen und derzeit handelsüblichen Bauelementen. Dadurch ist die Anordnung vorteilhafterweise sehr kostengünstig herstellbar.

Der Anordnung liegt die technische Aufgabe zugrunde, ein möglichst hochfrequentes moduliertes analoges Signal zu erzeugen, welches nach mindestens einer Aufwärtsmischung von einer Radarantenne ausgesandt, anschließend wieder empfangen und in der Radaranlage weiterverarbeitet werden kann. Dementsprechend sind die nachfolgend erwähnten Parameter, insbesondere die Taktfrequenz, gewählt. Für einen Fachmann, der eine vergleichbare technische Aufgabe, jedoch in einem anderen Frequenzbereich, lösen muß, bereitet es jedoch allenfalls geringe Schwierigkeiten, das Verfahren und die Anordnung, insbesondere die Taktfrequenzen und die Art der Technologie, z.B. die hier notwendige ECL- und GaAs-Technologie, an die Gegebenheiten der ihm gestellten technischen Aufgabe anzupassen.

Bei der Anordnung gemäß FIG. 2 soll ein Signal, z.B. gemäß FIG. 1, das im Frequenzbereich von 1MHz bis 39 MHz liegt bei einer Mittenfrequenz von 20 MHz, in ein gleiches analoges Signal mit einer Mittenfrequenz von 60 MHz umgewandelt werden. Jeder Stützstelle in FIG. 1 entspricht ein Zeitintervall von 12,5 ns. Bei dieser Anordnung ist zur Verringerung der PROM-Auslesegeschwindigkeit angenommen, daß die Stützwerte in zwei verschiedenen PROMs, nämlich PROM A und PROM B, gespeichert werden. So werden beispielsweise die zu geradzahligen Stützstellen gehörenden Stützwerte, die auch vereinfachend geradzahlige Stützwerte genannt werden und bei denen keine Vorzeichenumkehr erfolgte, nur in PROM A gespeichert. Die zu ungeradzahligen Stützstellen gehörenden Stützwerte, die ungeradzahlige Stützwerte genannt werden und bei denen eine Vorzeichenumkehr erfolgte, werden nur in PROM B gespeichert. PROM A und PROM B werden angesteuert durch einen Adressenzähler, der durch einen 40MHz-Takt gesteuert wird. Der Adressenzähler, z.B. ein Aufwärtszähler, zählt, gesteuert durch ein Start-Stop Flip-Flop, die Adressen, welche den Nummern der Stützstellen entsprechen, beginnend von einer Anfangs-Adresse, z.B. 0, immer bis zu einer End-Adresse, z.B. gemäß FIG. 1 bis ungefähr 3500. Anschließend erfolgt ein Zurücksetzen auf die Anfangs-Adresse. Dieser Vorgang kann, gesteuert durch einen Starttrigger, z.B. einmalig, mehrmalig nacheinander oder periodisch erfolgen. Zu jeder Adresse, welche den Nummern der Stützstellen entsprechen, wird aus PROM A oder PROM B der zugehörige Stützwert ausgelesen. So wird z.B. bei der Adresse "0" aus PROM A der zugehörige geradzahlige Stützwert ausgelesen. Bei der Adresse "1" wird dann aus PROM B der zugehörige ungeradzahlige Stützwert ausgelesen. Bei der Adresse "2" erfolgt dann wieder das Auslesen des zugehörigen geradzahligen Stützwertes aus PROM A und so weiter. An den Eingängen D des den PROMs nachgeschalteten Zwischenregisters, das ebenfalls mit 40MHz getaktet wird, liegen immer, mit einen Zeitversatz von 12,5 ns, zwei benachbarte Stützwerte an, also ein geradzahliger und ein ungeradzahliger. Das Zwischenregister dient lediglich dazu, mögliche Schwankungen der Zugriffszeit ("access-time") der PROMs auszugleichen, so daß dem nachfolgend geschalteten Digital-Analog-Wandler taktsynchron genau definierte Daten aus den PROMs zugeführt werden. Das Zwischenregister kann daher entfallen, wenn die Zugriffszeiten der PROMs gleich sind. Der Digital-Analog-Wandler enthält einen Zweikanal-Multiplexer mit den Eingängen A-Daten, B-Daten und einem einzigen Multiplexer-Ausgang, an welchen der eigentliche einkanalige D/A-Wandler angeschlossen ist. Der Digital-Analog-Wandler, und damit auch der darin enthaltende Multiplexer, wird von einem 80MHz-Takt geschaltet (getaktet), von welchem auch der bereits erwähnte 40MHz-Takt mit Hilfe eines 2:1-Taktteilers abgeleitet wird.

Infolge dieser beschriebenen alternativen D/A-Wandlung benachbarter Stützwerte aus PROM A und PROM B entsteht nun an dem analogen Ausgang des Digital-Analog-Wandlers ein sehr hochwertiges analoges Zweiseitenbandsignal mit einer unterdrückten 40MHz-Trägerfrequenz, einem 20MHz-Seitenband (unteres Seitenband) und einem 60MHz-Seitenband (oberes Seitenband). Dieses Zweiseitenbandsignal wird einem Verstärker Ampl. zugeleitet, in dem gegebenenfalls eine Verstärkung sowie eine Impedanzanpassung für den nachgeschalteten 60MHz-Bandpaß durchgeführt wird. Dieser Bandpaß mit einer Mittenfrequenz von 60MHz ist im Durchlaßbereich sehr phasenlinear und hat trotzdem eine sehr hohe Unterdrückung des unerwünschten unteren Seitenbandes sowie weiterer unterwünschter Modulationsspektren bei höheren Frequenzlagen. An dem Ausgang des 60MHz-Bandpasses entsteht also ein analoges Ausgangssignal, das eine Mittenfrequenz von 60MHz besitzt und das ansonsten genau dem Signal gemäß FIG. 1 entspricht. Auf diese Weise ist also eine Transformation eines Signales von einem 20MHz-Basisbandes in ein 60MHz-Band möglich. Dieses 60MHz-Ausgangssignal wird durch mindestens einen Hochmischvorgang zu einem Sendesignal für eine Radarantenne aufbereitet.

Der in FIG. 2 angegebene Carry-Ausgang des Adresszählers bewirkt, daß nach dem Erreichen der End-Adresse das Start-Stop Flip-Flop zurückgesetzt und damit der Adresszähler, über den En(able)-Eingang, abgeschaltet wird. Ein aus dem Flip-Flop-Signal durch ein Verzögerungsregister abgeleitetes Torsignal beendet, unter Berücksichtigung der in der Anordnung vorhandenen Signallaufzeiten, etwas später die Aktivität des Digital-Analog-Wandlers.

Alternativ zu der beschriebenen Anordnung ist es möglich, den in dem Digital-Analog-Wandler enthaltenen Multiplexer wegzulassen. Dann muß auch lediglich ein einziges PROM verwendet werden und darin geradzahlige und ungeradzahlige Stützwerte abwechselnd gespeichert werden.

Ebenso ist es möglich, die bipolaren Signalstützstellen auf mehrere parallel geschaltete PROMs zu verteilen, um durch einen höheren Multiplexgrad den Auslese-Adreßwechsel weiter zu verlangsamen und damit die Geschwindigkeitsanforderungen an die PROMs zu reduzieren.

Weiterhin ist es möglich, mehrere unterschiedliche Signale in einem oder mehreren PROMs zu speichern, so daß bedarfsweise sehr schnell zwischen den verschiedenen Signalen umgeschaltet werden kann, z.B. nach dem Erreichen der End-Adresse mit Hilfe eines Signalauswahl-Signales (FIG. 2).

## Patentansprüche

1. Verfahren zur Erzeugung eines modulierten hochfrequenten elektrischen Signales für ein- sowie mehrmalige Abgabe dieses Signales, dadurch gekennzeichnet,
- daß das Signal zunächst amplituden- und phasenrichtig für eine Periodendauer für ein Basisband erzeugt wird,
- daß die Periodendauer in mehrere äquidistante Zeitintervalle entsprechend dem Abtasttheorem zerlegt wird und daß die Zeitintervalle fortlaufend numeriert werden,
- daß für jedes Zeitintervall ein Stützwert, welcher dem mittleren Amplitudenwert in dem Zeitintervall entspricht, bestimmt wird,
- daß bei benachbarten Stützwerten eine Vorzeichenänderung erfolgt,
- daß die Stützwerte gespeichert werden,
- daß die gespeicherten Stützwerte anschließend fortlaufend mindestens einmal ausgelesen werden mit einem Takt, der bezüglich des Zeitintervalls eine wesentlich kürzere Periodendauer besitzt, und
- daß die ausgelesenen Stützwerte anschließend durch eine Digital-Analog-Wandlung zu einem analogen Zweiseitenbandsignal zusammengesetzt werden.

2. Verfahren nach Anspruch 1, dadurch gekennzeichnet, daß das Zweiseitenbandsignal einem Bandpaß, welcher lediglich ein Seitenbandsignal durchläßt, zugeführt wird.

3. Verfahren nach Anspruch 1 oder Anspruch 2, dadurch gekennzeichnet, daß Stützwerte mit unterschiedlichen Vorzeichen in verschiedenen Speichern gespeichert werden und daß die Stützwerte anschließend mindestens einmal im Zeitmultiplexbetrieb ausgelesen werden, vor der Digital-Analog-Wandlung.

4. Verfahren nach einem der vorhergehenden Ansprüche, dadurch gekennzeichnet, daß für eine Radaranlage in dem Basisband phasen- sowie frequenzmodulierte Signale erzeugt werden und daß das daraus entstehende analoge Zweiseitenbandsignal einem Bandpaß, durch den das obere Seitenband ausgewählt wird, zugeführt.

5. Verfahren nach Anspruch 4, dadurch gekennzeichnet, daß das Basisband eine Mittenfrequenz von 20MHz besitzt und daß für das obere Seitenband eine Mittenfrequenz von 60MHz gewählt wird.

6. Anordnung zur Durchführung des Verfahrens nach einem der vorhergehenden Ansprüche, dadurch gekennzeichnet,
- daß mindestens zwei programmierbare Speicher (PROM A, PROM B) vorhanden sind,
- daß in einem der Speicher (PROM A) Stützwerte mit unverändertem Vorzeichen speicherbar sind,
- daß in dem anderen Speicher (PROM B) Stützwerte mit geändertem Vorzeichen speicherbar sind und
- daß zur Ansteuerung der Speicher (PROM A, PROM B) ein Adressenzähler vorhanden ist.

7. Anordnung nach Anspruch 6, dadurch gekennzeichnet, daß der Adressenzähler durch einen Start-Stop-Schalter, welcher zumindest ein einmaliges Auslesen der Speicher (PROM A, PROM B) ermöglicht, gesteuert ist.

8. Anordnung nach Anspruch 6 oder Anspruch 7, dadurch gekennzeichnet, daß den Speichern (PROM A, PROM B) jeweils ein Zwischenregister nachgeschaltet ist.

9. Anordnung nach einem der Ansprüche 6 bis 8, dadurch gekennzeichnet,
- daß zumindest zwei Speicher (PROM A, PROM B) vorhanden sind,
- daß zum Auslesen der Speicher ein Multiplexer vorhanden ist und
- daß an den Ausgang des Multiplexers ein D/A-Wandler angeschlossen ist.

## Claims

1. Method of generating a modulated high-frequency electric signal for a non-recurrent as well as recurrent issue of this signal,
characterised thereby
- that the signal is initially generated correct in amplitude and phase for a cycle time for a base band,
- that the cycle time is resolved into several equidistant time intervals corresponding to the scanning theorem and that the time intervals are consecutively numbered,
- that a support value, which corresponds to the mean amplitude value in the time interval, is determmined for each time interval,
- that a change in sign is effected for adjacent support values,
- that the support values are stored,
- that the stored support values are subsequently read out consecutively at least once at a cycle which has a substantially shorter cycle time in relation to the time interval, and
- that the read-out support values are subsequently combined into an analog double side-band signal by a digital-to-analog conversion.

2. Method according to claim 1, characterised thereby that the double side-band signal is fed to a band-pass filter which transmits merely a side-band signal.

3. Method according to claimm 1 or claim 2, characterised thereby that the support values with different signs are stored in different stores and that the support values are subsequently read out at least once in time multiplex operation before the digital-to-analog conversion.

4. Method according to one of the preceding claims, characterised thereby that for a radar installation phase-modulated as well as frequency-modulated signals are generated in the base band and that the analog double side-band signal arising therefrom is fed to a band-pass filter, by which the upper side band is selected.

5. Method according to claim 4, characterised thereby that the base band has a centre frequency of 20 MHz and that a centre frequency of 60MHz is selected for the upper side band.

6. Arrangement for carrying out the method according to one of the preceding claims, characterised thereby
- that at least two programmable stores (PROM A, PROM B) are present,
- that support values with unchanged sign are storable in one of the stores (PROM A),
- that support values with changed sign are storable in the other store (PROM A), and
- that an address counter for selective driving of the stores (PROM A, PROM B) is present.

7. Arrangement according to claim 6, characterised thereby that the address counter is controlled by a stop-start switch, which enables at least one single reading out of the stores (PROM A, PROM B).

8. Arrangement according to claim 6 or claim 7, characterised thereby that a respective intermediate register is connected downstream of each of the stores (PROM A, PROM B).

9. Arrangement according to one of claims 6 to 8, characterised thereby
- that at least two stores (PROM A, PROM B) are present,
- that a multiplexer is present for reading out of the stores, and
- that a digital-to-analog converter is connected to the output of the multiplexer.

## Revendications

1. Procédé de génération d'un signal électrique à haute fréquence modulé pour un prélèvement unique ou multiple de ce signal, caractérisé ,
- en ce que le signal est tout d'abord généré en amplitude et en phase correcte pour une durée de période pour une bande de base,
- en ce que la durée de période est séparée en plusieurs intervalles de temps équidistants correspondants au théorème d'analyse et en ce que des intervalles de temps sont numérotés de façon ordonnée,
- en ce que, pour chaque intervalle de temps, une valeur d'appui, qui correspond à la valeur d'amplitude centrale dans l'intervalle de temps, est déterminée,
- en ce que, pour des valeurs d'appui adjacentes, un changement de signe est effectué,
- en ce que les valeurs d'appui sont mémorisées,
- en ce que les valeurs d'appui mémorisées sont lues ensuite de façon ordonnée au moins une fois avec une horloge, qui possède par rapport à l'intervalle de temps, une durée de période sensiblement plus courte, et
- en ce que les valeurs d'appui lues sont transformées ensuite par une conversion numérique/analogique en un signal analogique à deux bandes latérales.

2. Procédé selon la revendication 1, caractérisé en ce que le signal à deux bandes latérales est appliqué à un filtre passe-bande ne laissant passer qu'un signal à une bande latérale.

3. Procédé selon la revendication 1 ou la revendication 2, caractérisé en ce que des valeurs d'appui de signes différents sont mémorisées dans différentes mémoires et en ce que les valeurs d'appui sont lues ensuite au moins une fois par multiplexage temporel, avant la conversion numérique/analogique.

4. Procédé selon l'une quelconque des revendications précédentes, caractérisé en ce que, pour une installation radar, sont générés des signaux modulés en phase ainsi qu'en fréquence en bande de base et en ce que le signal à deux bandes latérales analogique en résultant est appliqué à un filtre passe-bande, grâce auquel est sélectionnée la bande latérale supérieure.

5. Procédé selon la revendication 4, caractérisé en ce que la bande de base possède une fréquence centrale de 20 MHz et en ce que, pour la bande latérale supérieure, est choisie une fréquence centrale de 60 MHz.

6. Dispositif de mise en oeuvre du procédé selon l'une des revendications précédentes, caractérisé en ce que,
- au moins deux mémoires programmables (PROM A, PROM B) sont prévues,
- en ce que, dans l'une des mémoires (PROM A), peuvent être mémorisées des valeurs d'appui avec des signes non modifiés,
- en ce que, dans l'autre mémoire (PROM B), des valeurs d'appui peuvent être mémorisées avec un signe modifié, et
- en ce que, pour la commande des mémoires (PROM A, PROM B), est prévu un compteur d'adresses.

7. Dispositif selon la revendication 6, caractérisé en ce que le compteur d'adresses est commandé par un commutateur marche-arrêt, qui permet au moins une seule lecture des mémoires (PROM A, PROM B).

8. Dispositif selon la revendication 6 ou la revendication 7, caractérisé en ce qu'en aval des mémoires (PROM A, PROM B) est disposé un registre intermédiaire.

9. Dispositif selon l'une des revendications 6 à 8, caractérisé
- en ce qu'au moins deux mémoires (PROM A, PROM B) sont prévues,
- en ce que, pour la lecture des mémoires, est prévu un multiplexeur, et
- en ce qu'à la sortie du multiplexeur est relié un convertisseur numérique/analogique.
